Europäisches Patentamt

European Patent Office

Office européen des brevets

(19)

(11) Veröffentlichungsnummer: **0 008 675**
**B1**

(12) **EUROPÄISCHE PATENTSCHRIFT**

(45) Veröffentlichungstag der Patentschrift: **13.07.83**

(21) Anmeldenummer: **79102737.8**

(22) Anmeldetag: **31.07.79**

(51) Int. Cl.³: **H 03 H 15/02,**
**H 03 H 19/00, H 01 L 27/10**

(54) Integrierte Filterschaltung.

(30) Priorität: **31.08.78 DE 2838006**

(43) Veröffentlichungstag der Anmeldung:
**19.03.80 Patentblatt 80/6**

(45) Bekanntmachung des Hinweises auf die Patenterteilung:
**13.07.83 Patentblatt 83/28**

(84) Benannte Vertragsstaaten:
**BE FR GB IT NL**

(73) Patentinhaber: **SIEMENS AKTIENGESELLSCHAFT**
**Berlin und München Wittelsbacherplatz 2**
**D-8000 München 2 (DE)**

(72) Erfinder: **Pfleiderer, Hans-Jörg, Dr.**
**Franz-Krinninger-Weg 23**
**D-8011 Zorneding (DE)**

(56) Entgegenhaltungen:
CONFERENCE RECORD, 1978 International
Conference on Communications: Vol. 3 (IEEE
Catalog Nr. 78CH1350-8 CSCB), Toronto,
Canada 4.—7. Juni 1978, Seiten 4.5.1.1.—
4.5.1.7 New York, U.S.A. M. A. COPELAND:
"Some Aspects of Sampled-Analog Mos LSI
Circuits for Communications"
DER ELEKTRONIKER, Vol. 15, Nr. 7, Juli 1976,
Seiten EL-6—EL-11 Aarau, CH. O. MULLER:

(56) Entgegenhaltungen:
"Halbleiterfilter auf einen Chip"
WISSENSCHAFTLICHE BERICHTE AEG-
TELEFUNKEN, Vol. 52, Nr. 1,2, Januar—Februar
1979, Seiten 131—138 Berlin, DE. P.
CHRISTIANSEN et al.: "Integration von Filtern
mit linearen MOS-Schaltungen"
ARCHIV FÜR ELEKTRONIK UND
ÜBERTRAGUNGSTECHNIK, Bd. 32, Nr. 10,
Oktober 1978 Seiten 381—389 Stuttgart, DE. E.
LÜDER: "Integrierbare Filter in VLSI-Technik"

Integrierte Filterschaltung

Die Erfindung bezieht sich auf eine integrierte Filterschaltung nach dem Oberbegriff des Patentanspruches 1.

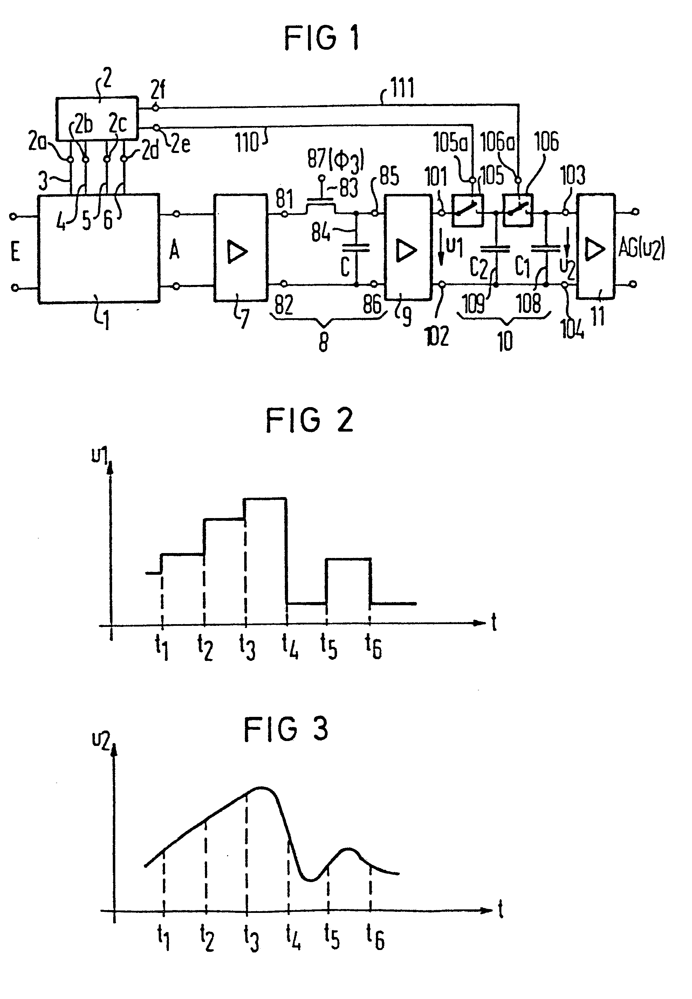

Eine derartige Schaltung ist beispielsweise aus dem Buch von Séquin und Tompsett "Charge Transfer Devices", Academic Press, New York, 1975, Seiten 54 bis 56, insbesondere Fig. 3.16 und zugehöriger Text, bekannt.

Der Erfindung liegt die Aufgabe zugrunde, eine Filterschaltung dieser Art durch ein weiteres ausgangsseitiges Filter zu ergänzen, das zur Glättung des von der Abtast- und Haltestufe gelieferten Ausgangssignals dient.

Das wird erfindungsgemäß durch die im kennzeichnenden Teil des Patentanspruchs 1 angegebenen Schaltungsmaßnahmen erreicht. Die Ansprüche 2 bis 9 kennzeichnen vorteilhafte Ausführungsformen und Weiterbildungen des Gegenstandes des Patentanspruchs 1.

Der mit der Erfindung erzielbare Vorteil liegt insbesondere darin, daß das die Glättung des Ausgangssignals bewirkende Filter in einfacher Weise integriert und insbesondere zusammen mit der übrigen Filterschaltung auf einem chip angeordnet werden kann, da es wenig Halbleiterfläche beansprucht. Außerdem kann das weitere Filter so ausgebildet werden, daß es trotz seines geringen Platzbedarfs die Frequenzcharakteristik eines Tiefpasses mit einer im kHz-Bereich liegenden Grenzfrequenz aufweist, wodurch seine Glättungseigenschaften sehr stark ausgeprägt werden.

Eine Filterschaltung, die einen ersten Kondensator, einen zweiten, wesentlich kleineren Kondensator sowie swei alternierend batätigbare elektronische Schalter aufweist, wobei über den einen Schalter ein Umladestromkreis für den zweiten Kondensator und über den anderen Schalter ein Umladestromkreis für eine aus beiden Kondensatoren gebildete Serienschaltung verläuft, ist aus dem Conference Record, 1978, International Conference on Communications, Vol 3 (IEEE Katalog-Nr. 78 CH 1350-8 CSCB) Toronto, Canada, 4. bis 5. Juni 1978, Seiten 4.5.1.1. bis 4.5.1.7, bekannt.

Die Erfindung wird nachfolgend anhand der Zeichnung näher beschrieben. Dabei zeigt:

Fig. 1 eine Prinzipdarstellung eines bevorzugten Ausführungsbeispiels der Erfindung,

Fig. 2 ein Spannungs-Zeit-Diagramm zur Erläuterung der Schaltung von Fig. 1,

Fig. 3 ein weiteres Spannungs-Zeit-Diagramm zur Erläuterung der Schaltung von Fig. 1,

Fig. 4 eine alternative Ausführungsform zu einer Teilschaltung von Fig. 1,

Fig. 5 eine Weiterbildung einer Teilschaltung von Fig. 1,

Fig. 6 eine bevorzugte Ausführungsform eines in den Figuren 1 und 5 enthaltenen Verstärkers und

Fig. 7 eine andere Ausführungsform des in den Figuren 1 und 5 enthaltenen Verstärkers.

In Fig. 1 stellt der Block 1 ein an sich bekanntes CTD-Transversalfilter dar, wie es beispielsweise in dem Buch von Séquin und Tompsett "Charge Transfer Devices", Academic Press, New York, 1975, auf den Seiten 216 bis 232 beschrieben ist. Andere Ausführungsformen von CTD-Transversalfiltern, die hierunter ebenfalls verstanden sein sollen, sind dem Aufsatz "CTD-Transversalfilter with Parallel-In/Serial-Out Configuration" von K. Knauer, H.-J. Pfleiderer und H. Keller in den Siemens-Forschungs- und Entwicklungs-Berichten, Band 7, 1978, Nr. 3, Seiten 1 bis 5 entnehmbar. Der Signaleingang des Transversalfilters ist mit E, der Filterausgang mit A bezeichnet. Ein Taktspannungsgenerator 2 weist Ausgänge 2a bis 2d auf, an denen gleichfrequente, gegeneinander phasenverschobene Taktspannungen $\emptyset_1$ bis $\emptyset_4$ abgreifbar sind, die über Leitungen 3 bis 6 den Verschiebeelektroden einer im einzelnen nicht dargestellten Ladungsverschiebeanordnung (CTD), die einen wesentlichen Bestandteil des Transversalfilters 1 darstellt, in herkömmlicher Weise zugeführt werden.

Der Ausgang A des CTD-Transversalfilters 1 ist über einen Verstärker 7, der einen hochohmigen Eingangswiderstand aufweist, mit dem Eingang 81, 82 einer Abtastund Haltestufe 8 verbunden, die einen Feldeffekt-Schalttransistor 83 und einen in einem Querzweig 84 liegenden Speicherkondensator C aufweist. Der Ausgang 85, 86 der Abtast- und Haltestufe 8 ist über einen Verstärker 9, der ebenfalls einen hochohmigen Eingangswiderstand besitzt, mit dem Eingang 101, 102 eines weiteren Filters 10 verbunden, dessen Ausgang 103, 104 über einen Verstärker 11 mit hohem Eingangswiderstand mit dem Schaltungsausgang AG verbunden ist.

Dem Gateanschluß 87 des Feldeffekt-Schalttransistors 83 wird die Taktspannung $\emptyset_3$ des CTD-Transversalfilters 1 zugeführt. Beim Auftreten jedes Taktimpulses von $\emptyset_3$ wird die Source-Drain-Strecke von 83 leitend, so daß sich der Kondensator C auf den zu diesem Zeitpunkt vorhandenen Momentanwert des Transversalfilter-Ausgangssignals, das an den Schaltungspunkten 81, 82 abgegriffen wird, auflädt bzw. umlädt. Fig. 2 zeigt den zeitlichen Verlauf der an C auftretenden, in 9 verstärkten Spannung $u_1$, wobei die Zeitpunkte des Auftretens der Taktimpulse von $\emptyset_3$ jeweils mit $t_1$ bis $t_6$ bezeichnet sind. Man erkennt in der schematischen Darstellung von Fig. 2 den treppenförmigen Verlauf von $u_1$. Durch die glättende Wirkung des als Tiefpaß ausgebildeten, weiteren Filters 10 ergibt sich dann am Schal-

tungsausgang AG ein Spannungsverlauf $u_2$ gemäß Fig. 3.

In Fig. 1, weist das Filter 10 einen ersten Kondensator $C_1$, einen zweiten, wesentlich kleineren Kondensator $C_2$ und zwei alternierend betätigbare elektronische Schalter 105 und 106 auf. Dabei sind diese Schaltelemente zu einer Vierpolschaltung mit dem Eingang 101, 102 und dem Ausgang 103, 104 zusammengefaßt.

Die Schalter 105 und 106 sind in Serie zueinander im Längszweit 107 dieser Vierpolschaltung vorgesehen, während der erste Kondensator $C_1$ in einen ausgangsseitigen Querzweig 108 und der zweite Kondensator $C_2$ in einen zwischen den Schaltern 105 und 106 angeschalteten Querzweig 109 eingefügt sind.

Der Taktspannungsgenerator 2 besitzt weitere Ausgänge 2e und 2f, an denen zwei gleichfrequente, gegeneinander phasenverschobene Taktspannungen abgreifbar sind, die den Steuereingängen 105a und 106a der Schalter 105 und 106 über Leitungen 110 und 111 zugeführt werden.

Die zwischen den Schaltungspunkten 101, 102 und 103, 104 liegende Vierpolschaltung ist an sich aus dem "IEEE Journal of Solid State Circuits, Vol. SC-12, No. 6, Dez. 1977, Seiten 592 bis 599, insbesondere Figuren 1 und 2, bekannt. Wie auch aus der Beschreibung zu den genannten Figuren dieser Veröffentlichung hervorgeht, findet bei einer alternierenden Betätigung der Schalter 105 und 106, wobei zunächst 105 geschlossen wird und 106 offenbleibt, während anschließend 106 öffnet und 105 schließt, zunächst eine Aufladung von $C_2$ auf die Amplitude eines bei 101, 102 abgegriffenen Signals statt, während anschließend die Kondensatoren $C_1$ und $C_2$ über den Längszweig 107 und die Querzweige 108 und 109 in einen Stromkreis eingeschaltet werden, in dem sie in Serie zueinander liegen, so daß eine teilweise Übertragung der Ladung von $C_2$ auf $C_1$ erfolgen kann.

Unter der Annahme, daß die Kapazität von $C_1$ wesentlich größer ist als die von $C_2$—als Beispiel hierfür sie ein Größenverhältnis von 100:1 genannt—und eine periodische Betätigung der Schalter 105 und 106 mit einer Periode T erfolgt, simuliert die Vierpolschaltung 10 ein RC-Tiefpaßfilter mit einem ohmschen Widerstand R im Längszweig 107 und dem Kondensator $C_1$ im Querzweig 108, wobei der Wert von R dem Quotienten $T/C_2$ entspricht. Hierbei ist unter $C_2$ die Kapazität des Kondensators $C_2$ zu verstehen. Wählt man die Periode T zu 10 $\mu s$, was einer Taktfrequenz der den Schaltern 105 und 106 zugeführten Taktspannungen von 100 kHz entspricht, und bemißt die Kondensatoren $C_1$ und $C_2$ derart, daß ihre Kapazitäten im Verhältnis von 100:1 stehen, so ergibt sich bei einer Kapazität von 10 pF für $C_1$ im Längszweig 107 der Vierpolschaltung ein äquivalenter ohmscher Widerstand von 1 M$\Omega$ und für das Teifpaßfilter eine Grenzfrequenz von etwa 10 kHz. Bei einem CTD-Transversalfilter 1, das mit einer Taktfrequenz von 16 kHz betrieben wird, erzielt man hierdurch bereits eine deutliche Glättung des Spannungsverlaufes $u_1$.

Der Verstärker 11 kann in Fig. 1 auch entfallen, wenn der Ausgang AG der integrierten Filterschaltung nach der Erfindung hochohmig abgeschlossen wird, d.h. mit einem Widerstand, der wesentlich größer ist als 1 m$\Omega$.

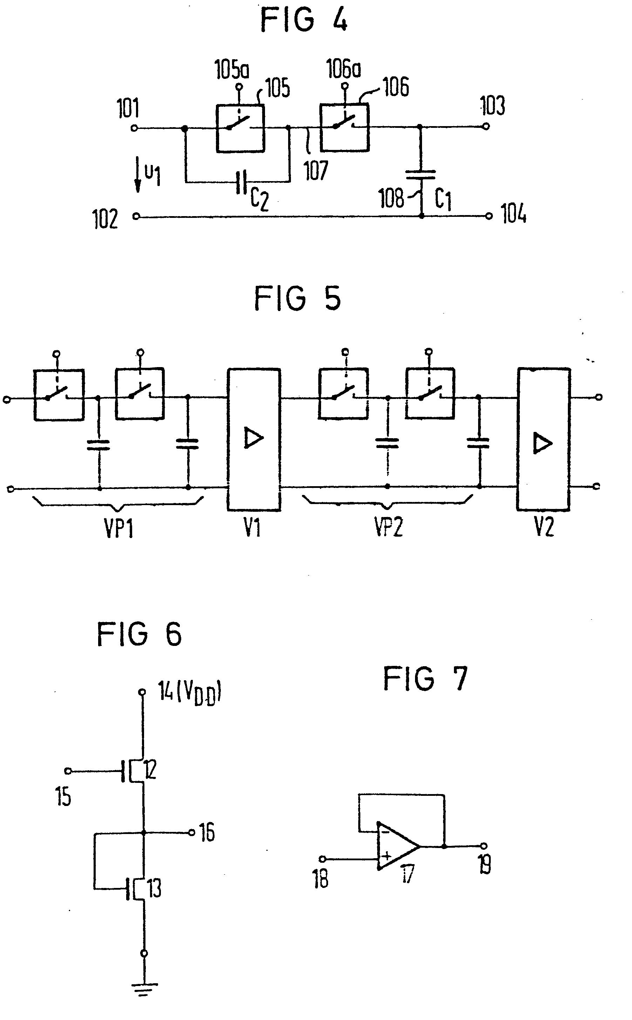

Fig. 4 zeigt eine andere Ausführungsform der Vierpolschaltung 10, die anstelle der oben beschriebenen in Fig. 1 einzusetzen ist. Die bereits anhand von Fig. 1 beschriebenen Schaltungsteile und Anschlußpunkte sind in Fig. 4 mit den gleichen Bezugszeichen versehen. Zum Unterschied von Fig. 1 ist der Kondensator $C_2$ nunmehr dem Schalter 105 parallel geschaltet. Damit ergibt sich in der ersten Schaltphase, in der der Schalter 105 geschlossen ist, während der Schalter 106 geöffnet bleibt, eine Entladung von $C_2$ über den Schalter 105, während in der zweiten Schaltphase (105 geöffnet, 106 geschlossen) ein Ladekreis für die aus $C_1$ und $C_2$ gebildete Serienschaltung hergestellt wird, dessen Anschlüsse 101, 102 an einer Spannung liegen, die durch den Amplitudenwert eines anliegenden Eingangssignals $u_1$ gegeben ist. Unter der Voraussetzung, daß $C_1$ eine wesentlich größere Kapazität aufweist als $C_2$, gilt die bereits anhand von Fig. 1 dargelegt Beziehung, nach der der Längszweig 107 einen ohmschen Widerstand simuliert, dessen Wert den Quotienten T/C entspricht, wobie T die Periode der die Schalter 105 und 106 betätigenden Taktspannungen und $C_2$ die Kapazität des Kondensators $C_2$ bedeuten.

Die Glättungseigenschaften des weiteren Filters können noch wesentlich verbessert werden, wenn anstelle einer einzigen Vierpolschaltung 10 eine Kaskadenschaltung aus mehreren solchen Schaltungen, von denen jede durch einen ausgangsseitigen Verstärker mit hohem Eingangswiderstand ergänzt ist, vorgesehen wird. In Fig. 5 ist eine zweistufige Kaskadenschaltung dieser Art dargestellt, wobei die einzelnen Vierpolschaltungen mit VP1 und VP2 bezeichnet sind, die abschließenden Verstärker mit V1 und V2. Selbstverständlich können die Vierpole VP1 und VP2 auch gemäß Fig. 4 ausgebildet sein.

Fig. 6 zeigt eine bevorzuge Ausführungsform der Verstärker 7, 9, 11, V1 und V2, die als eine mit MIS-Feldeffekttransistoren besückte Source-Folger-Stufe aufgehaut ist. Es sind zwei Feldeffekttransistoren 12 und 13 mit ihren Source-Drain-Strecken in Serie geschaltet, wobei der Drainanschluß von 12 mit einem die Versorgungsspannung $V_{DD}$ führenden Anschluß 14 verbunden ist, während der Sourceanschluß von 13 mit Massepotential beschaltet ist. Der Gateanschluß 15 des Transistors 12 bildet den Verstärkereingang, während der Verstärkeausgang 16 an den Sourceanschluß des Transistors 12 gelegt ist. Der Gateanschluß des ein Lastelement darstellenden Transistors 13 ist mit seinem Drainanschluß verbunden, sofern der Transistor 13 vom Anreicherungstyp ist. Handelt es sich bei 13 um einen Transistor vom Verarmungstyp, so ist sein Gate mit seinem Sourceanschluß zu verbinden.

Fig. 7 zeigt eine andere Ausführungsform der Verstärker 7, 9, 11, V1 und V2. Hierbei ist ein Operationsverstärker 17 vorgesehen, dessen Ausgang 19 mit seinem negativen Eingang verbunden ist, während seinem positiven Eingang 18 das zu verstärkende Signal zugeführt wird. Die Schaltung nach Fig. 7 stellt eine Realisierung eines Leistungsverstärkers mit hochohmigem Eingangswiderstand dar.

Die elektronischen Schalter 105 und 106 können mit Vorteil als Feldeffekt-Schalttransistoren realisiert werten, deren isoliert Gateelektroden an die Steuereingänge 105a und 106a geführt sind. Ein besonders günstiges und störfreies Betriebsverhalten ergibt sich für die Filterschaltung nach der Erfindung, wenn die Frequenz der den Steuereingängen 105a und 106a zugeführten Taktspannungen ein ganzzahliges Vielfaches der Frequenz der dem CTD-Transversalfilter zugeführten Verschiebetaktspannungen $\emptyset_1$ bis $\emptyset_4$ darstellt.

## Patentansprüche

1. Integrierte Filterschaltung mit einem CTD-Transversalfilter (1) und einer ausgangsseitigen Abtast- und Haltestufe (8), dadurch gekennzeichnet, daß ausgangsseitig von der Abtast- und Haltestufe (8) ein als Teifpaß ausgebildetes, weiteres Filter (10) vorgesehen ist, das einen ersten Kondensator ($C_1$), einen zweiten, wesentlich kleineren Kondensator ($C_2$) sowie zwei alternierend betätigbare elektronische Schalter (105, 106) aufweist, daß über den einen Schalter (105) ein Umladestromkreis für den zweiten Kondensator ($C_2$) und über den anderen Schalter (106) ein Umladestromkreis für eine aus beiden Kondensatoren ($C_1$, $C_2$) gebildete Serienschaltung verläuft und daß ein Taktspannungsgenerator (2) vorgesehen ist, der Ausgänge (2e, 2f) für zwei gegeneinander phasenverschobene erste Taktspannungen aufweist, die mit Steuereingängen (105a, 106a) der elektronischen Schalter (105, 106) verbunden sind, sowie weitere Ausgänge (2a, bis 2d) für zweite, ein niedrigere Frequenz aufweisende Taktspannungen ($\emptyset_1$ bis $\emptyset_4$), die zum Betrieb des CTD-Transversalfilters (1) dienen.

2. Filterschaltung nach Anspruch 1, dadurch gekennzeichnet, daß das weitere Filter (10) aus einem Vierpol besteht, in dessen Längszweig (107) die beiden Schalter (105, 106) in Serie zueinander angeordnet sind, und daß der erste Kondensator ($C_1$) in einen ausgangsseitigen Querzweig (108) und der zweite Kondensator ($C_2$) in einen zwischen den Schaltern (105, 106) angeschlossenen Querzweig (109) eingefügt sind (Fig. 1).

3. Filterschaltung nach Anspruch 1, dadurch gekennzeichnet, daß das weitere Filter (10) aus einem Vierpol besteht, in dessen Längszweig (107) der zweite Schalter (106) in Serie zu einer Parallelschaltung aus dem ersten Schalter (105) und dem zweiten Kondensator ($C_2$) angeordnet ist, und daß der erste Kondensator ($C_1$) in einen ausgangsseitigen Querzweig (108) eingefügt ist (Fig. 4).

4. Filterschaltung nach einem der Ansprüche 1 bis 3, dadurch gekennzeichnet, daß das weitere Filter einen Verstärker (11) mit einem hochohmigen Eingangswiderstand aufweist, dessen Eingang dem ersten Kondensator ($C_1$) parallel geschaltet ist und dessen Ausgang den Ausgang (AG) der Filterschaltung bildet.

5. Filterschaltung nach einem der Ansprüche 2 bis 4, dadurch gekennzeichnet, daß das weitere Filter aus einer Kaskadenschaltung von mehreren Vierpolen (VP1, VP2) mit jeweils ausgangsseitig angeordneten Verstärkern (V1, V2) mit hochohmigen Eingangswiderständen besteht (Fig. 5).

6. Filterschaltung nach einem der Ansprüche 1 bis 5, dadurch gekennzeichnet, daß zwischen dem Transversalfilter (1) und der Abtast- und Haltestufe (8) sowie zwischen dieser und dem weiteren Filter (10) jeweils ein Verstärker (7, 9) mit hochohmigem Eingangswiderstand vorgesehen ist.

7. Filterschaltung nach einem der Ansprüche 4 bis 6, dadurch gekennzeichnet, daß die Verstärker (7, 9, 11, V1, V2) jeweils aus einer in MIS-Technik realisierten Source-Folger-Stufe (12, 13) bestehen (Fig. 6).

8. Filterschaltung nach einem der Ansprüche 4 bis 6, dadurch gekennzeichnet, daß die Verstärker (7, 9, 11, V1, V2) jeweils aus einem Leistungsverstärker mit hochohmigen Eingangswiderstand besteht, der mit einem Operationsverstärker (17) bestückt ist (Fig. 7).

9. Filterschaltung nach Anspruch 1, dadurch gekennzeichnet, daß die Frequenz der ersten Taktspannungen ein ganzzahliges Vielfaches der Frequenz der zweiten Taktspannungen ist.

## Revendications

1. Circuit de filtre avec un filtre transversal CTD (1) et avec un étage de balayage et de maintien (8) situé du côté sortie, caractérisé par le fait que du côté sortie de l'étage de balayage et de maitien (8), il est prévu un filtre supplémentaire (10) réalisé sous la forme d'un passe bas et comportant un premier condensateur ($C_1$), un second condensateur ($C_2$) notablement plus petit ainsi que deux commutateurs électroniques (105, 106) susceptibles d'être actionnés alternativement, que par l'un (105) des commutateurs passe un circuit de courant d'inversion pour le second condensateur ($C_2$) et par l'autre commutateur (106) passe un circuit de courant d'inversion pour un montage série formé par les deux condensateurs ($C_1$, $C_2$), et qu'il est prévu un générateur de tension de cadence (2) présentant des sorties (2e, 2f) pour deux premières tensions de cadence déphasées entre elles, qui sont reliées à des entrées de commande (105a, 106a) des commutateurs électroniques (105, 106) ainsi que d'autres sorties (2a à 2d) pour des secondes tensions de cadence ($\Phi_1$ à $\Phi_4$) de faible fréquence et servant au fonctionnement du filtre transversal CTD (1).

2. Circuit de filtre selon la revendication 1, caractérisé par le fait que le filtre supplémentaire (10) est constitué par un quadripôle dans la branche longitudinale (107) duquel sont disposés, en série entre eux, les deux commutateurs (105, 106), et que le premier condensateur ($C_1$) est inséré dans une branche transversale (108) située du côté sortie alors que le second condensateur ($C_2$) est inséré dans une branche transversale (109) qui est branchée entre les commutateurs (105, 106) (figure 1).

3. Circuit de filtre selon la revendication 1, caractérisé par le fait que le filtre supplémentaire est constitué par un quadripôle dans la branche longitudinale (107) duquel est disposé le second commutateur (106) en série avec un montage parallèle constitué par le premier commutateur (105) et le second condensateur ($C_2$), et que le premier condensateur ($C_1$) est inséré dans une branche transversale (108) située du côté sortie (figure 4).

4. Circuit de filtre selon l'une des revendications 1 à 3, caractérisé par le fait que le filtre supplémentaire comporte un amplificateur (11) avec une résistance d'entrée fortement ohmique, dont l'entrée est montée en parallèle avec le condensateur ($C_1$) et dont la sortie constitue la sortie (AG) du circuit de filtre.

5. Circuit de filtre selon l'une des revendications 2 à 4, caractérisé par le fait que le filtre supplémentaire est constitué par un montage en cascade de plusieurs quadripôles (VP1, VP2) avec respectivement des amplificateurs (V1, V2) disposés du côté sortie et à résistances d'entrée fortement ohmiques (figure 5).

6. Circuit de filtre selon l'une des revendications 1 à 5, caractérisé par le fait qu'entre le filtre transversal (1) et l'étage de balayage et de maintien (8), de même qu'entre ce dernier et le filtre supplémentaire (10) est prévu, respectivement, un amplificateur (7, 9) à résistance d'entrée fortement ohmique.

7. Circuit de filtre selon l'une des revendications 4 à 6, caractérisé par le fait que les amplificateurs (7, 9, 11, V1, V2) sont respectivement constitués par un étage à source suiveuse (12, 13), réalisé dans la technique MIS (figure 6).

8. Circuit de filtre selon l'une des revendications 4 à 6, caractérisé par le fait que les amplificateurs (7, 9, 11, V1, V2) sont respectivement formés par un amplificateur de charge à résistance d'entrée fortement ohmique, et, pourvu d'un amplificateur opérationnel (17) (figure 7).

9. Circuit de filtre selon la revendication 1, caractérisé par le fait que la frequence des premières tensions de cadence est un multiple entier de la fréquence des secondes tensions de cadence.

## Claims

1. Integrated filter circuit comprising a CTD transversal filter (1) and an output-end sample-and-hold stage (8) characterised in that, at the output end of the sample-and-hold stage (8) there is arranged a further filter (10) which is designed as a low-pass filter and which comprises a first capacitor ($C_1$) a second, basically smaller capacitor ($C_2$), and two alternately operable electronic switches (105, 106), that via the first switch (105) there runs a recharging circuit for the second capacitor ($C_2$) and via the other switch (106) there runs a recharging circuit for a series arrangement comprising the two capacitors ($C_1$, $C_2$), and that a clock pulse voltage generator (2) is provided which has outputs (2E, 2F) for two first clock pulse voltages which are displaced in phase relative to one another and which are connected to control inputs (105a, 106a) of the electronic switches (105, 106), and further outputs (2a to 2d) for second clock pulse voltages ($\emptyset_1$ to $\emptyset_4$) having a lower frequency and which serve to operate the CTD transversal filter (1).

2. Filter circuit as claimed in claim 1, characterised in that, the further filter (10) comprises a four-pole network whose series arm (107) contains the two switches (105, 106) in series with one another, and that the first capacitor ($C_1$) is inserted into an output-end shunt arm (108), whereas the second capacitor ($C_2$) is inserted into a shunt arm (109) connected between the switches (105, 106) (Fig. 1).

3. Filter circuit as claimed in claim 1, characterised in that, the further filter (10) comprises a four-pole network whose series arm (107) contains the second switch (106) in series with a parallel arrangement comprising the first switch (105) and the second capacitor ($C_2$), and that the first capacitor ($C_1$) is inserted into an output-end shunt arm (108) (Fig. 4).

4. Filter circuit as claimed in one of the claims 1 to 3, characterised in that, the further filter comprises an amplifier (11) having a high-ohmic input resistance, whose input is connected in parallel with the first capacitor ($C_1$) and whose output forms the output (AG) of the filter circuit.

5. Filter circuit as claimed in one of the claims 2 to 4, characterised in that, the further filter comprises a cascade arrangement of a plurality of four-pole networks (VP1, VP2) each comprising amplifiers (V1, V2) which are arranged at the output end and having high-ohmic input resistances (Fig. 5).

6. Filter circuit as claimed in one of the claims 1 to 5, characterised in that both between the transversal filter (1) and the sample-and-hold stage (8), and likewise between the latter and the further filter (10) there is in each case arranged an amplifier (7, 9) which has a high-ohmic input resistance.

7. Filter circuit as claimed in one of the claims 4 to 6, characterised in that, the amplifiers (7, 9, 11, V1, V2) each comprise a source-follower stage (12, 13) constructed in MIS technology (Fig. 6).

8. Filter circuit as claimed in one of the claims 4 to 6, characterised in that, the amplifiers (7, 9, 11, V1, V2) each comprise a power amplifier having a high-ohmic input resistance and is equipped with an operational amplifier (7) (Fig. 7).

9. Filter circuit as claimed in claim 1, characterised in that, the frequency of the first clock pulse voltages amounts to a whole numbered multiple of the frequency of the second clock pulse voltages.

# FIG 1

# FIG 2

# FIG 3

# FIG 4

# FIG 5

# FIG 6

# FIG 7